# EUROPEAN PATENT APPLICATION

(11) **EP 2 040 375 A1**
(43) Date of publication of application: **25.03.2009**
(21) Application number: 07018399.1
(22) Date of filing: 19.09.2007
(51) Int. Cl.: H03F 1/30, H03F 1/32, H03F 1/02, H03F 3/21, H04L 27/36

(54) **Power amplifier module and method of generating a drain voltage for a power amplifier**

(71) Applicant: Nokia Siemens Networks Oy, 02610 Espoo (FI)
(72) Inventor: Jelonnek, Björn, Dr., 89079 Ulm (DE)
(74) Representative: Bruglachner, Thomas E.

(57) **Abstract**

A power amplifier module (300) is provided, which comprises a power supply unit (304) having an input connector and an output connector, and a power amplifier (303) having an input terminal, wherein the output connector of the power supplying unit (304) is connected to the input terminal of the power amplifier (303), wherein the power supply unit (304) is adapted to generate a variable drain voltage from an undefined stabilized voltage applied to the input connector and supply the variable drain voltage to the output connector.

## Description

### Field of invention

The present invention relates to the field of power amplifier modules. Furthermore, the invention relates to a method of generating a drain voltage, in particular for a power amplifier. Moreover, the invention relates to a power amplifier system.

### Art Background

With newly introduced radio communication systems, such as the EDGE or the UMTS mobile radio system for example, linear forms of modulation are used in which a constant instantaneous power of a transmit signal is dispensed with. A maximum transmit signal amplitude which arises in such a case typically lies significantly above the average value of an associated transmit power. In addition there are plans with the newly introduced radio communication systems to use multicarrier data transmission procedures (multicarrier approach) in which a plurality of transmit signals with different carrier frequencies are modulated with a high carrier frequency spacing and fed to a transmit amplifier. A coherent overlaying of all transmitted signals in this case means that maximum amplitudes occur which lie far above the average value of the associated transmit power. A transmitter power amplifier must accordingly retain sufficient reserves of power for a linear amplifier operation.

Non-linearities of the transmit power amplifier effect the efficiency of the entire radio communication system. The non-linearities disadvantageously cause intermodulation products of which the carrier frequencies act as interference to disturb the carrier frequencies to be used. These disruptive interferences are suppressed by executing what is referred to as a predistortion of a power amplifier input signal. A distinction is to be made here between an "analogue" and a "digital predistortion", with the digital predistortion offering easier reproducibility and higher flexibility.

Although, transmission systems comprising a predistortion of a signal are known it may still be desirable to further improve such a system.

### Summary of the Invention

There may be a need for a power amplifier module, a method of generating a drain voltage, and a power amplifier system, wherein the power amplifier module provides an improved performance.

This need may be met by a power amplifier module, a method of generating a drain voltage, and a power amplifier system according to the independent claims. Further embodiments of the present invention are described by the dependent claims.

According to an exemplary embodiment a power amplifier module is provided, which comprises a power supply unit having an input connector and an output connector, and a power amplifier having an input terminal, wherein the output connector of the power supplying unit is connected to the input terminal of the power amplifier, wherein the power supply unit is adapted to generate a variable drain voltage from an undefined stabilized voltage applied to the input connector and supply the variable drain voltage to the output connector. In particular, the power supply unit may be formed by a drain voltage generator. For example, the power supply unit may comprise or may be formed by a drain modulator which functioning is based upon drain modulation. For example, such a power amplifier module may be used in mobile radio system.

According to an exemplary embodiment a method of generating a drain voltage for a power amplifier module according to an exemplary embodiment is provided, wherein the method comprises providing an undefined stabilized voltage to the power supply unit, generating a variable drain voltage from the undefined stabilized voltage, and outputting the variable drain voltage to the input terminal of the power amplifier.

According to an exemplary embodiment a power amplifier system is provided which comprises a power amplifier module according to an exemplary embodiment, a predistortion unit, and a parameter estimation unit, wherein the predistortion unit is coupled to the power amplifier module and to the parameter estimation unit, and wherein the power amplifier module is coupled to the parameter estimation unit. Furthermore, the parameter estimation unit is adapted to provide a broadband parameter estimation for the predistortion unit based on an output of the power amplifier module. In particular, the power amplifier system may form a transmission system.

By providing a power amplifier module having a power supply unit adapted to generate a variable drain voltage out of a stabilized undefined voltage which variable drain voltage is fedable to a power amplifier it may be possible to save an extra power supply unit commonly used to provide a voltage having a defined and constant level. This may lead to the fact that the performance and/or efficiency of the power amplifier module and/or of a power amplifier system may be improved, since no extra power supply solely for generating a constant voltage level is used.

The power supply unit, e.g. a drain modulator, may perform a voltage stabilization. In particular, the drain modulator may be functionally based on the known drain modulation effect according to which a drain voltage for a power amplifier may be generated according to a reference signal.

A gist of an exemplary embodiment may be seen in that an efficient power amplifier module may be provided having a power supply unit adapted to generate a variable drain voltage for the power amplifier directly from a variable power supply. Thus, no specific power unit for generating a constant voltage which in turn is used to generate the variable drain voltage for the power amplifier. For example, a drain modulator is used as the power supply unit for generating the variable drain voltage. In particular, the use of a power amplifier module according to an exemplary embodiment may enable a predistortion of broadband input signals. In general, a predistortion of broadband input signals is desired. For such a broadband predistortion an iterative procedure may be used, e.g. as described in DE 103 20 420 which is incorporated herein by reference.

Next, further exemplary embodiments of the power amplifier module are described. However, these embodiments also apply to the method of generating a drain voltage, and the power amplifier system.

According to another exemplary embodiment of the power amplifier module the power supply unit comprises a sigma-delta converter. In particular, the power supply unit may be formed by a sigma-delta converter. Additionally, a sigma-delta converter may be combined with an amplifier, e.g. a switchable amplifier.

A sigma-delta converter may be a suitable device to provide a variable drain voltage for the power amplifier of a power amplifier module.

According to another exemplary embodiment of the power amplifier module the sigma-delta converter is a one-bit sigma-delta converter. In particular, a one-bit sigma-delta converter may be used having a high linearity. Furthermore, the one-bit sigma-delta converter may have a low band width compared to a sampling rate of the sigma-delta converter.

The provision of a one-bit sigma-delta converter may be a suitable measure to provide a variable drain voltage in an efficient manner.

According to another exemplary embodiment of the power amplifier module the sigma-delta converter is a multi-bit sigma-delta converter. In particular, the multi-bit sigma-delta converter may be adapted to control the gain and/or the phase in an adaptive way.

The provision of a multi-bit sigma-delta converter may be a suitable measure to ensure a broadband application of the respective power amplifier module. In particular, by providing an adaptive gain and/or phase control or regulation it may be possible to reduce quantification noise. A more detailed description of the sigma-delta-converter is given in WO 03052938.

According to another exemplary embodiment the power amplifier module further comprises a supervision unit, wherein the supervision unit is adapted to monitor the variable drain voltage. In particular, the supervision unit may comprise or may be formed by a reference receiver, e.g. by a reference receiver already used by a predistortion subunit of a power amplifier system comprising a power amplifier module according to an exemplary embodiment.

The provision of such a supervision unit may ensure that no reference voltage may have to be generated, so that a respective power amplifier module may be simplified. Furthermore, it may be possible to stabilize the spurious free dynamic range by monitoring and/or measuring the drain voltage by using the supervision unit. That is, it may be possible to avoid the reducing of the spurious free dynamic range which may be induced by different voltage levels in cases in which more than one power amplifier module each having a respective power supplying unit are used in a power amplifier system. By using a correlation between known signals of a single power amplifier the amplitude of the variable drain voltage may be deducible.

According to another exemplary embodiment of the power amplifier module the supervision unit is used to monitor the variable drain voltage and the power amplifier output signal by using a switching unit for choosing the desired input signal.

According to another exemplary embodiment of the power amplifier module the power supply unit further comprises a further input connector, wherein the further input connector is adapted to receive a reference signal. In particular, the reference signal may be a digital or an analogue reference signal.

Next, further exemplary embodiments the power amplifier system further comprises a plurality of power amplifier modules, and a plurality of predistortion units, wherein each of the plurality of power amplifier modules is connected to a respective one of the plurality of predistortion units, and wherein the parameter estimation unit is coupled to each of the plurality of predistortion units.

It has to be noted that embodiments of the invention have been described with reference to different subject matters. In particular, some embodiments have been described with reference to apparatus type claims whereas other embodiments have been described with reference to method type claims. However, a person skilled in the art will gather from the above and the following description that, unless otherwise notified, in addition to any combination of features belonging to one type of subject matter also any combination between features relating to different subject matters, in particular between features of the apparatus type claims and features of the method type claims is considered to be disclosed within this application.

The aspects and exemplary embodiments defined above and further aspects of the invention are apparent from the example of embodiment to be described hereinafter and are explained with reference to these examples of embodiment.

### Brief Description of the Drawings

Fig. 1 schematically shows a block diagram of a first transmission system in which a power amplifier module according to an exemplary embodiment may be implemented.
Fig. 2 schematically shows a block diagram of a drain modulation.
Fig. 3 schematically shows a block diagram of a drain modulation according to a first exemplary embodiment.
Fig. 4 schematically shows a block diagram of a drain modulation according to a second exemplary embodiment.
Fig. 5 schematically shows some simulation results for a sigma-delta converter.
Fig. 6 schematically shows a block diagram of a drain modulation according to a third exemplary embodiment.
Fig. 7 schematically shows a block diagram of a second transmission system in which a power amplifier module according to an exemplary embodiment may be implemented.
Fig. 8 schematically shows a block diagram of a digital predistortion system.

### Detailed Description

The illustration in the drawings is schematic. It is noted that in different figures, similar or identical elements are provided with the similar or identical reference signs.

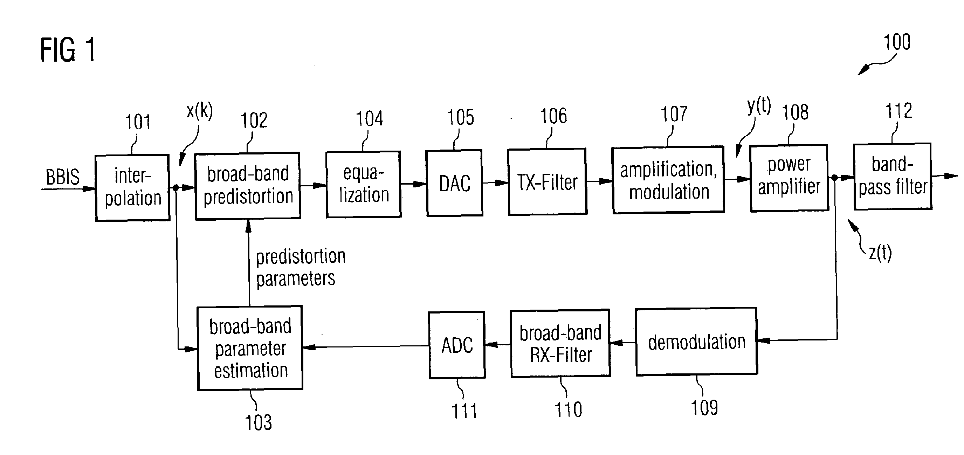

With reference to Fig. 1 a block diagram of a first transmission system in which a power amplifier module according to an exemplary embodiment may be implemented is described.

**FIG. 1** shows a basic block diagram of a transmission system 100 comprising a predistortion. A complex digital baseband input signal BBIS arrives via an interpolation device 101 as a signal x(k) both at a device for broadband predistortion 102 of a main branch as also at a device for broadband parameter estimation 103.

The device for broadband predistortion 102 is a series circuit with a compensator device 104 or equalizer to compensate for linear distortions, with a D/A converter 105, with a transmit filter TxF 106 causing linear distortions, with a modulator 107 and with the transmit power amplifier 108 connected downstream.

At the output of the modulator 107 a signal y(t) is present which is fed via the transmit power amplifier 108 as a highfrequency multicarrier signal z(t) to a feedback branch. The feedback branch features, connected in series, a demodulator 109, a broadband receive filter RxF1 110 and an A/D converter 111, which is connected on the output side to the device for broadband parameter estimation 103. The device for broadband parameter estimation 103 is connected to the device for broadband predistortion 102, with estimated parameters reaching the device for broadband distortion 102.

The digital signal processing is undertaken at a higher digital sampling frequency, whereas converter types with a low sampling frequency can be used as D/A converter 105 or for A/D converter 111.

Outside a desired useful transmit signal band the amplitudes of mixed products arising are reduced by an additional analogue bandpass filter 112 connected downstream from the transmit power amplifier 108.

The device for broadband predistortion 102 needs wide band information about distortions of the entire transmission system shown as a block diagram in FIG. 1.

In this case the bandwidths and sampling frequencies of the A/D converter 105 or the D/A converter 111 used represent a basic problem. A wide bandwidth of the receive filter RxF1 110 is used such that the higher Nyquist frequencies are available for the A/D converter 105 due to subsampling, which allows the sampling frequency of the A/D converter 105 to be reduced.

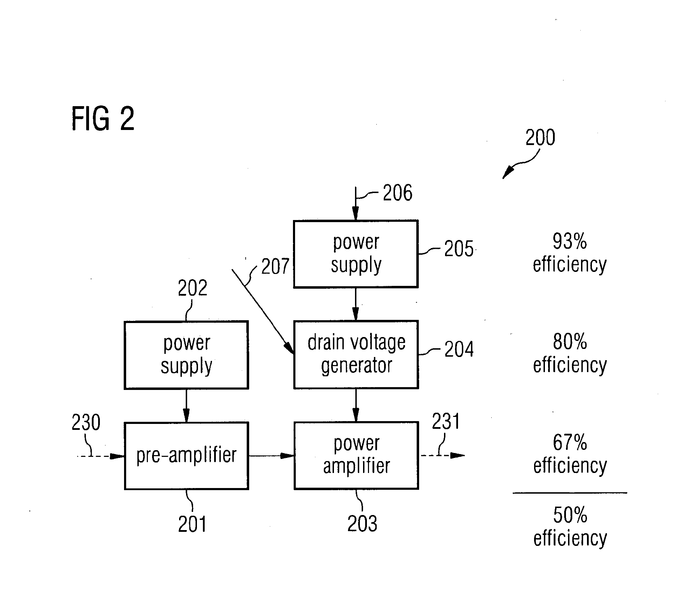

The power amplifier 108 shown in Fig. 1 only as one block may be formed by a power amplifier module comprising several subunit which will be described in more detail with reference to the Figs. 2 to 4 and 6.

**Fig. 2** schematically shows a block diagram of a drain modulation which can be used in a power amplifier module 200. The power amplifier module 200 comprises a pre-amplifier 201 and a respective first power supply 202. An output signal of the pre-amplifier 201 is transmitted to a power amplifier 203. A variable drain voltage is supplied to the power amplifier 203 by a drain voltage generator 204 which generate the variable drain voltage from a constant voltage supplied to it by a power supply 205. The power supply 206 in turn generates the constant voltage out of an undefined but stabilized voltage 206. Furthermore a digital or analogue reference signal 207 is supplied to the drain voltage generator 204. By the dotted lines 230 and 231 an input signal and an output signal of the power amplifier module are indicated, respectively.

On the right side of Fig. 2 estimations of the efficiencies of the single elements are depicted. For example the efficiency of the power supply 206 is about 93%, of the drain voltage generator about 80% and of the power amplifier about 67% which lead to a total efficiency of about 50%.

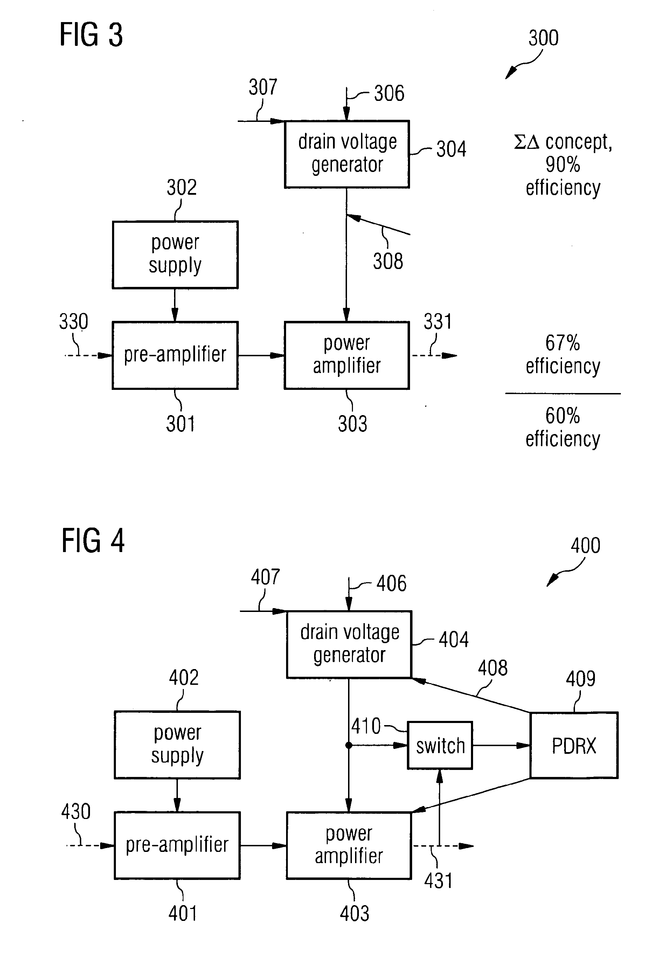

**Fig. 3** schematically shows a block diagram of a drain modulation which can be used in a power amplifier module 300 according to a first exemplary embodiment.

The power amplifier module 300 comprises a pre-amplifier 301 and a respective first power supply 302. An output signal of the pre-amplifier 301 is transmitted to a power amplifier 303. A variable drain voltage is supplied to the power amplifier 303 by a drain voltage generator 304 or power supply unit which generates the variable drain voltage out an undefined but stabilized voltage 306. Furthermore a digital or analogue reference signal 307 is supplied to the drain voltage generator 304. By the dotted lines 330 and 331 an input signal and an output signal of the power amplifier module are indicated, respectively.

Thus, compared to the power amplifier module shown in Fig. 2 the additional power supply, labeled 205 in Fig. 2, is saved, since the power supply unit 304 or drain voltage generator 304 itself is adapted to generate the variable drain voltage directly from the undefined but stabilized voltage 306. To improve the generation of the variable drain voltage it may be advantageous to provide a supervision of the variable drain voltage which is indicated by a supervision signal 308 in Fig. 3.

On the right side in Fig. 3 estimations of the efficiencies of the single elements are depicted. For example the efficiency of the drain voltage generator is about 90% and of the power amplifier about 67% which lead to a total efficiency of about 60%. Thus, the total efficiency is increased compared to the total efficiency of the module shown in Fig. 2.

**Fig. 4** schematically shows a block diagram of a drain modulation which can be used in a power amplifier module 400 according to a second exemplary embodiment.

The power amplifier module 400 comprises a pre-amplifier 401 and a respective first power supply 402. An output signal of the pre-amplifier 401 is transmitted to a power amplifier 403. A variable drain voltage is supplied to the power amplifier 403 by a drain voltage generator 404 or power supply unit which generates the variable drain voltage out an undefined but stabilized voltage 406. Furthermore a digital or analogue reference signal 407 is supplied to the drain voltage generator 404. By the dotted lines 430 and 431 an input signal and an output signal of the power amplifier module are indicated, respectively.

Thus, compared to the power amplifier module shown in Fig. 3 additional a supervision unit PDRX 409 is depicted which generates a supervision signal 408 associated with the variable drain voltage. The supervision unit may be formed by a reference receiver, e.g. by a reference receiver already used for other functions in the transmission system. Furthermore, the power amplifier module 400 comprises a switching unit 410 adapted to switch the supervision unit 409 based on the variable drain voltage and the output signal 431 of the power amplifier 403.

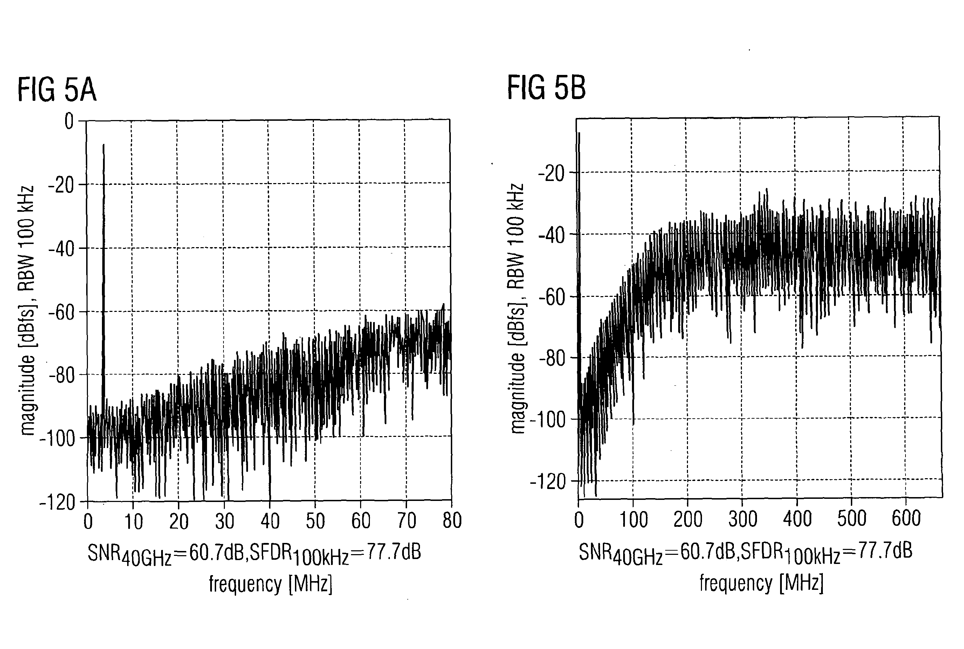

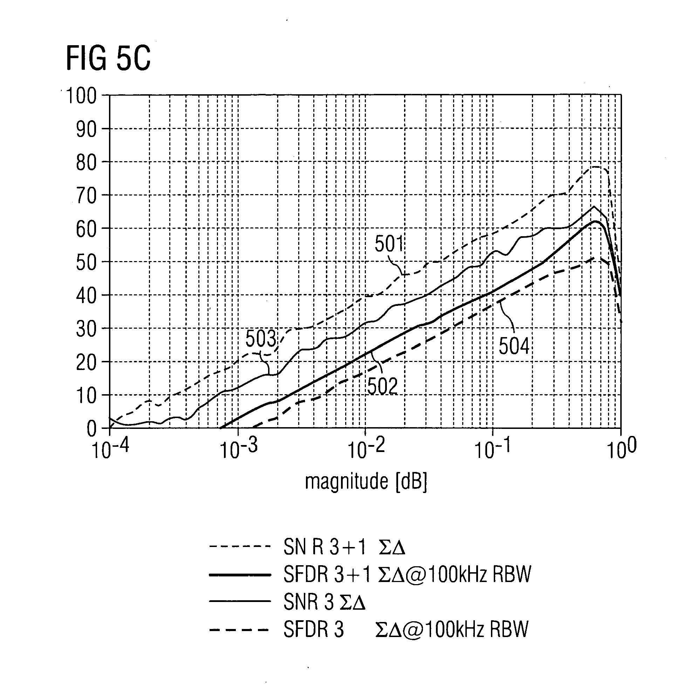

**Fig. 5** schematically shows some simulation results for a sigma-delta converter, i.e. for the case that the drain voltage generator is formed by a sigma-delta converter. Fig. 5 shows an output signal for such a sigma-delta converter. The so-called spurious free dynamic range (SFDR) of such a digital-analogue converter decreases, in case that the output powers of the used power amplifiers are different relative to each other. For the simulation the results of which are shown in Fig. 5 a relative difference of 5% was assumed. Furthermore, for the simulation a third order 3+1 bit digital to analogue converter and a 1 bit digital to analogue converter for noise cancellation were assumed.

In particular, Fig. 5a shows the results in decibel full scale of RBW signal at 100 kHz for different frequencies, namely between 0 MHz and 80 MHz, while Fig. 5b shows the results of simulated RBW signal at 100 kHz by frequencies between 0 MHz and 650 MHz. A more detailed description of the sigma-delta-converter is given in WO 03052938.

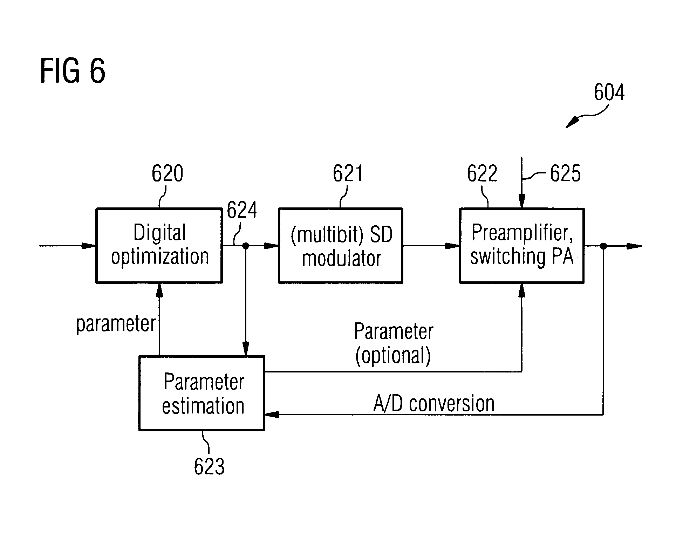

**Fig. 6** schematically shows a block diagram of a drain modulation according to a third exemplary embodiment. In particular, Fig. 6 shows a drain voltage generator 604. The drain voltage generator 604 comprises a digital optimization unit 620 receiving a complex baseband input signal. An output signal 624 of the optimization unit 620 is forwarded to a sigma-delta converter or modulator 621 and additionally to a parameter estimation unit 623. The sigma-delta modulator may be formed as a one-bit or a multi-bit sigma-delta modulator. An output signal of the sigma-delta modulator 621 is then forwarded to a pre-amplifier or switching amplifier 622 having as another input an undefined but stabilized voltage 625. An output of the pre-amplifier or switching amplifier 622 forms the output signal of the drain voltage generator 605 and is additionally forwarded to the parameter estimation unit 623 where it forms, after an optionally analogue digital conversion, a further input signal. The parameter estimation unit 623 estimates parameters used for the digital optimization unit 620 and optionally for the pre-amplifier 622 as well.

The block digital optimization calculates, based on the complex baseband input signal to be sent, the drain voltage. It may, for example, calculate the envelope of the signal to be sent, takes care of the distortion of the envelope by a non-linear characteristic, and performs the predistortion for the drain voltage generator.

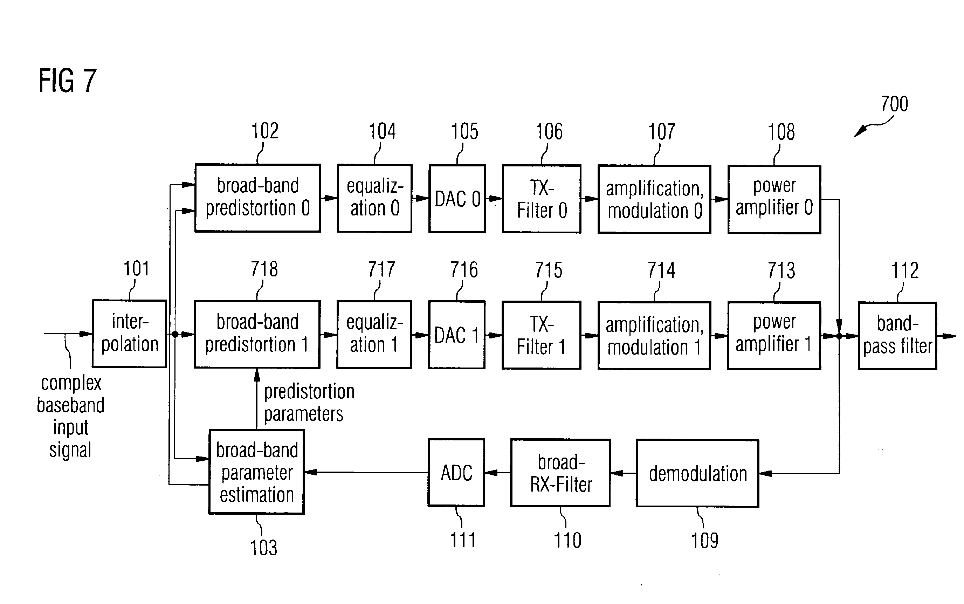

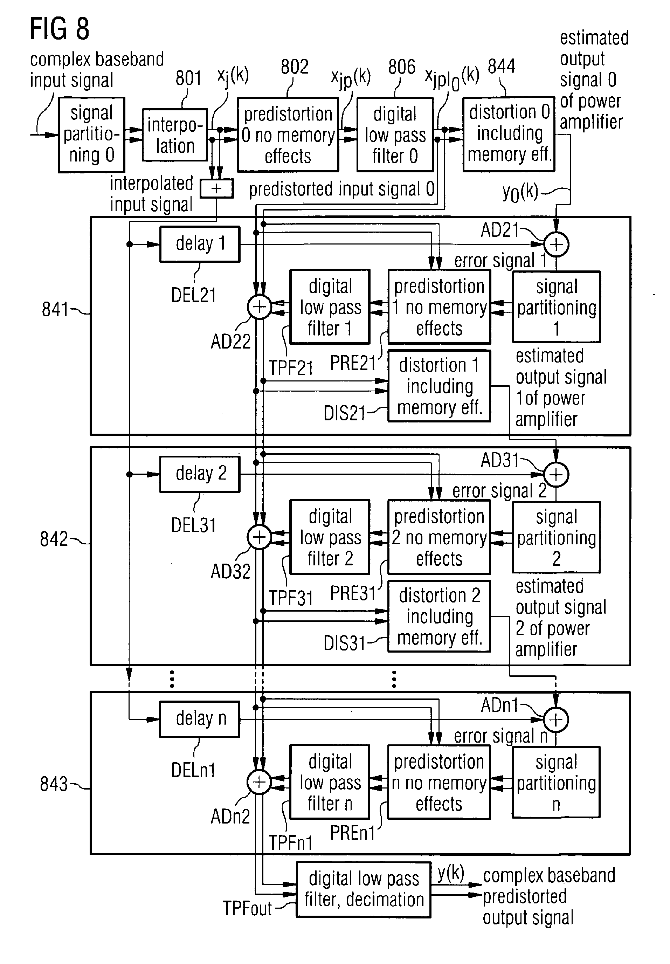

Figs. 7 and 8 schematically show systems in which a power amplifier module according to an exemplary embodiment of the invention may be used. In particular, **Fig. 7** shows a block diagram of a second transmission system in which a power amplifier module according to an exemplary embodiment may be implemented and which is similar to the one shown in Fig. 1 but comprises two paths each having a corresponding power amplifier or power amplifier module. Thus, the embodiment shown in Fig. 7 comprises the same elements as pictured and described in connection with Fig. 1. However, the additionally path further comprises a second power amplifier 713, a second amplification modulation 714, a second transmit filter 715, a second digital to analogue converter 716, a second equalization 717, and a second broadband predistortion 718.

**Fig. 8** schematically shows a block diagram of a digital predistortion system. In particular, the described system shown in Fig. 8 may be suitable for implementing an iterative predistortion procedure of input signals. Further details for such an iterative procedure may be gathered from DE 103 20 420.

A baseband input BBIS is partitioned, as input signal xᵢ(k) and passes via an interpolation unit 801 to arrive both at a first branch 840 designated as the main branch and also at further branches 841, 842 to the n^{th} branch 843, designated as auxiliary branches. The main branch and the auxiliary branches in this case represent the device for predistortion 718 described in Fig. 7.

With j=1 the first branch 840 contains, connected in series, a predistortion unit 802 which does not take account of any memory effects of the transmit power amplifier, a digital lowpass filter 806 and distortion unit 844 which takes account of the memory effects. The input signal xᵢ(k) arrives via the predistortion unit 802 as a signal xᵢₚ(k) at the lowpass filter 806. Its output signal arrives as signal xᵢₚₗₒ(k) via the predistortion unit 844 as signal y₀(k) at a second branch 841.

With 2<=j<=n-1 a j^{th} branch j features the following components connected in series to each other: A delay unit DELj1, of a first adder ADj1, a signal partitioning unit, a predistortion unit PREj1 which does not take account of any memory effects, a digital lowpass filter TPFj1, a second adder ADj2 and a predistortion unit DISj1 which takes account of memory effects.

With j=n the n^{th} branch n merely contains a series circuit with a delay unit DELn1, a first adder ADn1, a signal partitioning unit, a predistortion unit PREn1 which does not take account of any memory effects, a digital lowpass filter TPFn1 and a second adder ADn2.

With 2<=j<=n the input signal xᵢ(k) is connected on the input side to the delay unit DELj1 of the j^{th} branch j. The delay unit DELj1 is connected on the output side to a first input of the first adder ADj1, with an error signal being formed by addition here. The first adder ADj1 is connected to a signal partitioning unit which on the output side is connected on the output side to a first input of the predistortion unit PREj1, to which the error signal formed is fed. The predistortion unit PREj1 is connected downstream from the lowpass filter TPFj1 which is connected on the output side to a first input of the second adder ADj2.

With 2<=j<=sn the second adder ADj2 of the j^{th} branch j is connected on the output side on the one hand directly to a second input of the second adder AD(j+1)2 of a subsequent branch j+1 and to a second input of the predistortion unit PRE(j+1)1 of subsequent j+1^{th} branch j+1. On the other hand it is connected via the predistortion unit DISj1 to the j^{th} branch j to a second input of the first adder AD(j+1)1 of the j+1* branch j+1, the output of which is connected to a signal partitioning unit the output of which is in turn connected to the predistortion unit of the same branch.

With j=2, for the j^{th} branch j the second input of the second adder ADj2 and the second input of the predistortion unit PREj1 are connected to an output of the lowpass filter TPF11 of the first branch 840, while the second input of the first adder ADj1 is connected to an output of the predistortion unit 844 of the first branch 840.

With 1<=j<=n-1 a negated estimated signal of the transmit power amplifier is formed by the predistortion unit DISj1 of a j^{th} branch j and transferred to the second input of the first adder AD(j+1)1 of the subsequent branch in each case.

A summation signal formed by the second adder ADn2 of the n^{th} branch n passes through a digital lowpass filter TPFout to reach the subsequent transmit power amplifier as predistortion signal y(k). If the digital to analogue (D/A) converter used needs a low sample rate, a decimation of the sample rate can be undertaken here.

As regards simple implementation, the predistortion units 802 to PREn1 shown here implement a static predistortion with a non-linear characteristic curve. In this case memory effects of the transmit power amplifier are not taken into account.

For example a power series development can be calculated based on an equation which describes an average AM-AM and AM-PM characteristic of the transmit power amplifier for a mid frequency for example. This characteristic curve is for example applied inverted to the interpolated input data xᵢ(k).

The predistortion signal xᵢₚ(k) typically has a higher bandwidth than a D/A converter to be used. Therefore the bandwidth of the predistorted output signal y(k) from FIG. 8 will be reduced to the bandwidth of the multicarrier signal to be sent plus a frequency range at the band limits. Especially advantageously the above-mentioned lowpass filters 806 to TPFn1 are used with same frequency response as a D/A converter used later for band limitation of the input signal.

The predistorted signal xᵢₚ(k) undergoes degradation as a result of the band restriction. Higher frequency components especially are not correctly predistorted. The error signal described above is determined with reference to an estimated transmission function of the transmit power amplifier liable to memory effects by comparison with the transmitted and the corresponding time-delayed signal.

Viewed in conclusion, error signals are formed by the first adders AD21 to ADn1 in each case, which in the final analysis are fed to the second adders AD22 to ADn2 of the assigned branch. The distortion units 844 to DIS31 on the other hand form an estimated output signal of the transmit power amplifier, with the estimated output signal being formed to take into account memory effects of the transmit power amplifier. The second adders AD22 to ADn2 form on the output side a proportionate signal y(k), which is cascaded down to the last branch n through addition in each case, with the signal y(k) being formed after output-side filtering by the lowpass filter TPFout. In this case the signal xᵢₚₗₒ(k) of the first branch 840 shown is also viewed as a proportionate signal y(k) which is transferred to the subsequent branch 2. Digital filters embodied here or subsequently as lowpass filters can also be embodied as bandpass filters.

Finally, it should be noted that the above-mentioned embodiments illustrate rather then limit the invention, and that those skilled in the art will be capable of designing many alternative embodiments without departing from the scope of the invention as defined by the appended claims. In the claims, any reference signs shall not be construed as limiting the claims. The word "comprising" and "comprises", and the like, does not exclude the presence of elements or steps other than those listed in any claim or the specification as a whole. The singular reference of an element does not exclude the plural reference of such elements and vice-versa. In a device claim enumerating several means, several of these means may be embodied by one and the same item of software or hardware. The mere fact that certain measures are recited in mutually different dependent claims does not indicate that a combination of these measures cannot be used to advantage.

### List of reference signs:

- 100: transmission system
- 101: interpolation device
- 102: broadband predistortion
- 103: broadband parameter estimation
- 104: compensator device/equalizer
- 105: D/A converter
- 106: transmit filter
- 107: modulator
- 108: power amplifier
- 109: demodulator
- 110: receive filter
- 111: A/D converter
- 112: bandpass filter
- 200: power amplifier module
- 201: pre-amplifier
- 202: power supply
- 203: power amplifier
- 204: drain voltage generator/power supply unit
- 205: power supply
- 206: undefined but stabilized voltage
- 207: digital or analogue reference signal
- 230: input signal
- 231: output signal
- 300: power amplifier module
- 301: pre-amplifier
- 302: power supply
- 303: power amplifier
- 304: drain voltage generator/power supply unit
- 306: undefined but stabilized voltage
- 307: digital or analogue reference signal
- 308: supervision signal
- 330: input signal
- 331: output signal
- 400: power amplifier module
- 401: pre-amplifier
- 402: power supply
- 403: power amplifier
- 404: drain voltage generator/power supply unit
- 406: undefined but stabilized voltage
- 407: digital or analogue reference signal
- 408: supervision signal
- 409: supervision unit PDRX
- 410: switch
- 430: input signal
- 431: output signal
- 501: SNR 3+1 ΣΔ
- 502: SNR 3+1 ΣΔ @ 100kHz RBW
- 503: SNR 3 ΣΔ
- 504: SNR 3 ΣΔ @ 100kHz RBW
- 604: drain voltage generator/power supply unit
- 620: digital optimization unit
- 621: sigma-delta converter/modulator
- 622: pre-amplifier
- 623: parameter estimation unit
- 624: output signal
- 625: undefined but stabilized voltage
- 713: power amplifier
- 714: modulator
- 715: transmit filter
- 716: D/A converter
- 717: compensator device/equalizer
- 718: broadband predistortion
- 801: interpolation unit
- 802: predistortion unit
- 806: digital lowpass filter
- 840: first branch
- 841: second branch
- 842: third branch
- 843: n^{th} branch
- 844: predistortion unit

## Claims

1. A power amplifier module (300) comprising:
a power supply unit (304) having an input connector and an output connector,
a power amplifier (303) having an input terminal,
wherein the output connector of the power supplying unit (304) is connected to the input terminal of the power amplifier (303),
wherein the power supply unit (304) is adapted to generate a variable drain voltage from an undefined stabilized voltage applied to the input connector and supply the variable drain voltage to the output connector.

2. The power amplifier module (300) according to claim 1,
wherein the power supply unit (304) comprises a sigma-delta converter.

3. The power amplifier module (300) according to claim 2,
wherein the sigma-delta converter is a one-bit sigma-delta converter.

4. The power amplifier module (300) according to claim 2,
wherein the sigma-delta converter is a multi-bit sigma-delta converter.

5. The power amplifier module (300) according to claim 4,
wherein the multi-bit sigma-delta converter is adapted to control the gain and/or the phase in an adaptive way.

6. The power amplifier module (300) according to claim 1, further comprising:
a supervision unit (409),
wherein the supervision unit (409) is adapted to monitor the variable drain voltage.

7. The power amplifier module (300) according to claim 6,
wherein the supervision unit (409) is used to monitor the variable drain voltage and the power amplifier output signal by using a switching unit (410) for choosing the desired input signal.

8. The power amplifier module (300) according to claim 1,
wherein the power supply unit (304) further comprises a further input connector,
wherein the further input connector is adapted to receive a reference signal.

9. A method of generating a drain voltage for a power amplifier module (300) according to claim 1, the method comprising:
providing an undefined stabilized voltage to the power supply unit (304),
generating a variable drain voltage from the undefined stabilized voltage, and
outputting the variable drain voltage to the input terminal of the power amplifier (303).

10. A power amplifier system (100) comprising:
a power amplifier (108) module according to claim 1,
a predistortion unit (102), and
a parameter estimation unit (103),
wherein the predistortion unit (102) is coupled to the power amplifier (108) module and to the parameter estimation (103) unit, and
wherein the power amplifier (108) module is coupled to the parameter estimation unit (103),
wherein the parameter estimation unit (103) is adapted to provide a broadband parameter estimation for the predistortion unit based on an output of the power amplifier (108) module.

11. The power amplifier system (700) according to claim 10, further comprising:
a plurality of power amplifier (108, 713) modules, and
a plurality of predistortion units (102, 718),
wherein each of the plurality of power amplifier (108, 713) modules is connected to a respective one of the plurality of predistortion units (102, 718), and
wherein the parameter estimation unit (103) is coupled to each of the plurality of predistortion units (102, 718).

12. A mobile radio system comprising a power amplifier module according to claim 1.
